# EUROPEAN PATENT APPLICATION

(11) **EP 0 758 798 A2**
(43) Date of publication of application: **19.02.1997**
(21) Application number: 96113017.6
(22) Date of filing: 13.08.1996
(51) Int. Cl.: H01L 23/495

(54) **Semiconductor device with enhanced electrical characteristic**

(30) Priority: 14.08.1995 KR 2500495
(71) Applicant: Samsung Electronics Co., Ltd., Suwon-city, Kyungki-do (KR)
(72) Inventor: Choi, Chi-Young, Seocho-gu, Seoul (KR)
(74) Representative: Grünecker, Kinkeldey, Stockmair & Schwanhäusser Anwaltssozietät

(57) **Abstract**

The present invention relates to a semiconductor device for improving a noise characteristic by supplying a stable power within a chip. The semiconductor device has: a lead frame body for bonding a chip in a package, and transmitting power supply voltage; a plurality of main pads provided within the chip and connected to external pins through wires; dummy pads connected to the lead frame body through wires, capable of supplying power, and provided in edges of the chip; and power pad pins connected in common to the lead frame body and the main pads through wires, and provided with ground potential and power supply voltage.

## Description

### Background of the Invention

### 1. Field of the invention

The present invention relates to a semiconductor device with an enhanced electrical characteristic, and more particularly, to a semiconductor device for improving a noise characteristic by supplying a stable power within a chip.

The present application for a semiconductor device with an enhanced electrical characteristic, is based on Korean Application No. 25004/1995 which is incorporated herein by reference for all purpose.

### 2. Description of the Related Art

Recently, as various technical problems are being gradually solved with an improvement of a chipmaking technique, a high integration and high speed of a semiconductor device have been more emphasized. This, however, has created some problems such as a problem related to a noise characteristic. Furthermore, such a problem causes a malfunction of the product upon an operation and a latch-up, thereby resulting in a product destroy phenomenon. operation and a latch-up, thereby resulting in a product destroy phenomenon.

Therefore, various efforts for improving this noise characteristic have been made in a design or a manufacturing process filed.

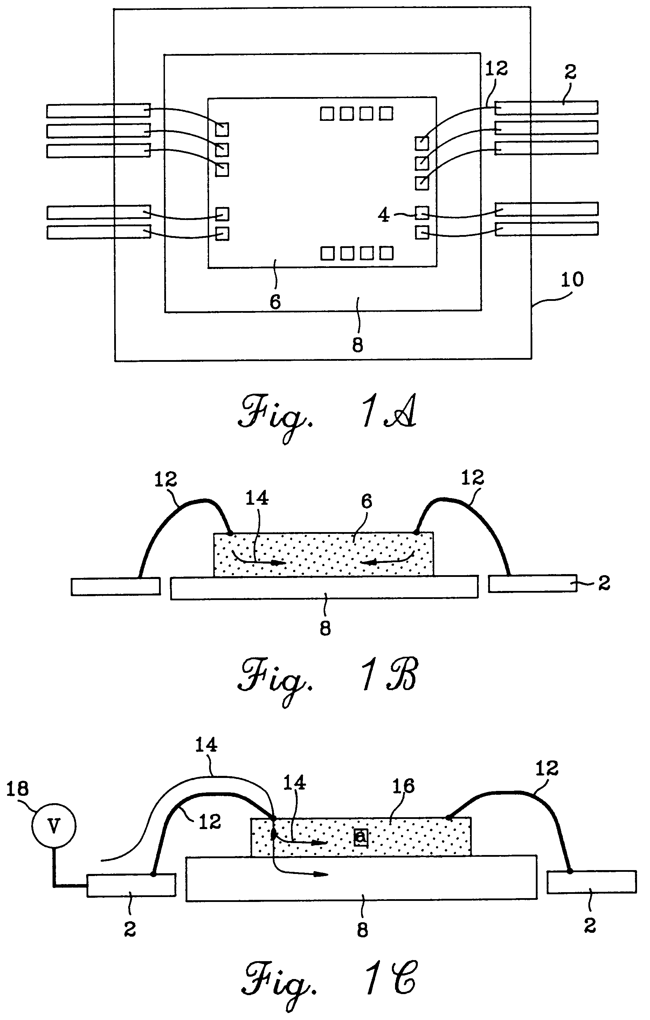

FIGs. 1A, 1B and 1C illustrate a conventional bonding method of a chip 6 and a pin 2. First, in FIGs. 1A and 1B, a lead frame body 8 is provided for bonding the chip 6, a plurality of pads 4s within the chip 6 are connected to a plurality of bonding wires 12s and then the plurality of bonding wires 12s are connected to a plurality of pins 2s. Thereby, the chip is provided with power from the pin.

In FIG. 1C illustrating a method of supplying the power within the chip 6 by a typical package 10, an electrical current 14 from the power source 18 is transmitted to the chip 6 and the lead frame body 8 through the bonding wire 12. At this time, the power transmitted to a block "a" may be derived from the following equation.$\text{Va = Vs-i × (RL + RW + RS × square number) < Vs.}$ Wherein, a "Va" represents a potential of the block "a", a "Vs" represents voltage of the power source 18, an "i" stands for the electrical current 14, an "RL" represents a resistance of a lead, an "RW" represents a resistance of the bonding wire 12, and an "RS" represents a resistance of a wafer substrate of the chip 6.

The resistance of the wafer substrate of the chip 6 reaches to several hundreds of ohms and due to this resistance, a voltage drop occurs at the drop point 16.

Accordingly, a voltage difference between the internal power occurs and thereby, the latch-up or the power supply voltage drop is generated. Due to this, a margin of the product can not be ensured. Moreover, the power is provided only through the power pad 4 and therefore, in case the pads are limited in the number thereof, the function of the chip may be unstablized due the limitation in the number of the power pads.

### Summary of The Invention

Accordingly, it is an object of the present invention to provide a semiconductor device for improving a noise characteristic.

It is another object of the present invention to provide a semiconductor device for improving a noise characteristic by supplying a stable power within a chip.

To achieve these and other objects, the present invention provides a semiconductor device for improving a noise characteristic by supplying a stable power within a chip, including: a lead frame body for bonding the chip in a package and transmitting power supply voltage; main pads provided within the chip, and connected to external pins through wires; dummy pads connected to the lead frame body by wires, capable of providing power supply, and formed in edges of the chip; and power pad pins to which ground potential and power supply voltage are applied.

### Brief Description of The Drawings

A more complete appreciation of this invention, and many of the attendant advantages thereof, will be readily apparent as the same becomes better understood by reference to the following detail description when considered in conjunction with the accompanying drawings, in which like reference symbols indicate the same or similar elements components, wherein:
FIGs. 1A, 1B and 1C illustrate a prior art bonding method of a chip 6 and a pin 2;
FIGs. 2A, 2B and 2C illustrate a bonding method of a chip 6 and a pin 2 in accordance with the present invention; and
FIGs. 3A, 3B and 3C respectively illustrate a difference between a resistance of a chip substrate having a size of 1cm and a resistance occurring upon a bonding of a lead frame body in accordance with the prior art and the present invention.

### Detailed Description of The Preferred Embodiment

Hereinafter, an embodiment of a preferred configuration and operation of the present invention will be described in detail with reference to the attached figures.

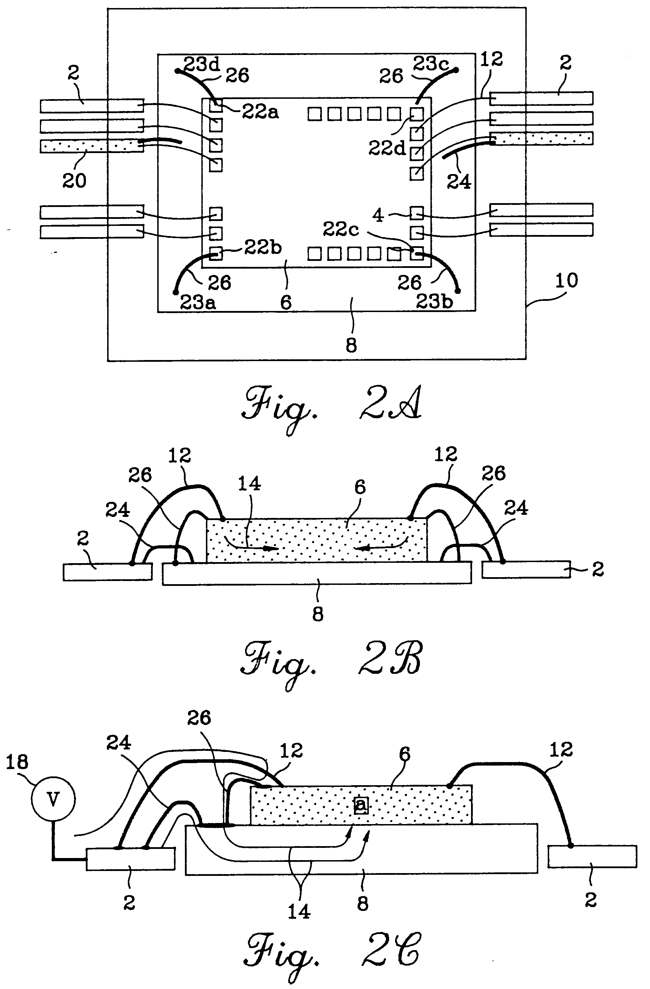

FIG. 2A, 2B and 2C illustrate a bonding method of the chip 6 and the pin 2 in accordance with the present invention. First, in FIGs. 2A and 2B, the lead frame body 8 is provided for bonding the chip 6 within the package 10, and a plurality of main pads 4s are provided within the chip 6 and connected to external pins by the wires. Dummy pads 23a, 23b, 23c and 23d connected to the lead frame body through the wires are formed in four edges of the chip for supplying the power source 18. The lead frame body 8 connected to the dummy pads is bonded to power pad pins 20s through bonding wires 24s. Then, if the wafer substrate of the chip is a P type substrate, the ground potential pad pin is employed in the lead frame body, and on the other hand, if the wafer substrate of the chip is an N type substrate, the power supply voltage pad pin is employed in the lead frame body. The main pads and the bonding wires are connected to each other, and then the bonding wires are connected to the plurality of pins 2s and 20s.

FIG. 2C illustrates the method of supplying the power within the chip by the package 10 in accordance with the present invention. The electrical current 14 from power source 18 is transmitted at the same time to the chip 6 and the lead frame body 8 through the bonding wire 12, the wire 26 for bonding the dummy pads and the lead frame body the wire 24 for the power pad and the lead frame body. The power which is then transmitted to the block "a" can be derived from the following equation.$\text{Va=Vs-i×(RL+RW+Rf)≒Va .}$ Wherein, an "Rf" represents a resistance of the lead frame body. At this time, since the voltage drop does not occur in the current flowing into the lead frame body, the power can be stably and vertically provided within the chip.

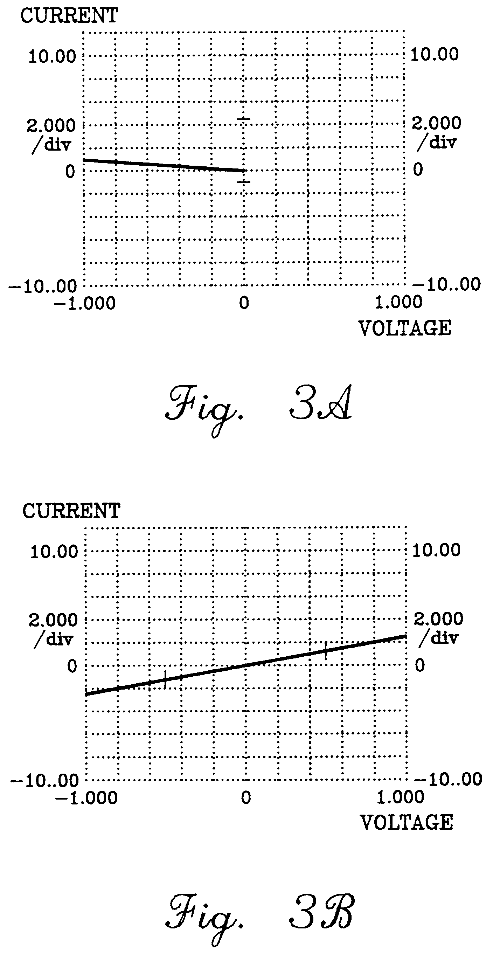

FIGs. 3A and 3B respectively illustrate the difference between the resistance of the substrate having the size of 1cm and the resistance occurring upon the bonding of the lead frame body in accordance with the prior art and the present invention. As seen in FIGs. 3A and 3B, the resistance occurring on the N type substrate is about 350ohm, and the resistance upon the bonding of the lead frame body is about 5ohm or below. Therefore, in the product sensitive to the noise, a voltage is substantially changed depending upon the electrical current during the operation time of the product, but the semiconductor device in accordance with the present invention has much stabler operation characteristic in view of the variation rate of the internal transistor.

Therefore, it should be understood that the present invention is not limited to the particular embodiment disclosed herein as the best mode contemplated for carrying out the present invention, but rather that the present invention is not limited to the specific embodiment described in this specification except as defined in the appended claims.

## Claims

1. A semiconductor device for improving a noise characteristic by supplying stable power within a chip, comprising:
a lead frame body for bonding a chip in a package, and transmitting power supply voltage;
a plurality of main pads provided within said chip and connected to external pins through wires;
dummy pads connected to said lead frame body through wires, capable of supplying power, and provided in edges of said chip; and
power pad pins connected in common to said lead frame body and said main pads through wires, and provided with ground potential and power supply voltage.

2. The semiconductor device as claimed in claim 1, wherein said power pads are embodied by ground potential pad pins when a substrate of said chip is a P type substrate, and are embodied by power supply voltage pad pins when said substrate of said chip is an N type substrate.

3. A method of improving a noise characteristic by supplying stable power within a chip in a semiconductor device, including the step of forming pad capable of supplying power according to a wafer substrate attribute in edges of said chip, and directly bonding said pads to a lead frame body.
